(19) Europäisches Patentamt
European Patent Office
Office européen des brevets

(11) **EP 1 816 484 B1**

(12) **FASCICULE DE BREVET EUROPEEN**

(45) Date de publication et mention
de la délivrance du brevet:
**15.04.2009 Bulletin 2009/16**

(51) Int Cl.:
***G01R 31/3183*** *(2006.01)*

(21) Numéro de dépôt: **07001557.3**

(22) Date de dépôt: **25.01.2007**

(54) **Procédé de détection d'un dysfonctionnement dans une machine d'état**

Verfahren zur Fehlererkennung einer Zustandsmaschine

Method for detecting a disfunction on a state machine

(84) Etats contractants désignés:
**DE FR GB IT**

(30) Priorité: **03.02.2006 FR 0600974**

(43) Date de publication de la demande:
**08.08.2007 Bulletin 2007/32**

(73) Titulaire: **STMicroelectronics SA**
**92120 Montrouge (FR)**

(72) Inventeurs:
• **Taillet, François**
**13710 Fuveau (FR)**
• **Murillo, Laurent**
**Les Olives, 13013 Marseille (FR)**

(74) Mandataire: **Marchand, André**
**OMNIPAT,**
**24 Place des Martyrs de la Résistance**
**13100 Aix-en-Provence (FR)**

(56) Documents cités:
**US-A- 4 727 548**

• **STOJCEV M K ET AL: "VHDL-based design of FSM with concurrent error detection capability" MICROELECTRONICS, 2004. 24TH INTERNATIONAL CONFERENCE ON NIS, SERBIA AND MONTENEGRO MAY 16-19, 2004, PISCATAWAY, NJ, USA,IEEE, vol. 2, 16 mai 2004 (2004-05-16), pages 759-762, XP010708749 ISBN: 0-7803-8166-1**
• **LEVEUGLE R ET AL: "Alternative approaches to fault detection in FSMs" DEFECT AND FAULT TOLERANCE IN VLSI SYSTEMS, 1994. PROCEEDINGS., THE IEEE INTERNATIONAL WORKSHOP ON MONTREAL, QUE., CANADA 17-19 OCT. 1994, LOS ALAMITOS, CA, USA,IEEE COMPUT. SOC, US, 17 octobre 1994 (1994-10-17), pages 271-279, XP010252398 ISBN: 0-8186-6307-3**

**EP 1 816 484 B1**

**Description**

La présente invention concerne les machines d'état, et en particulier celles utilisées dans les circuits intégrés.

Une machine d'état est une sorte d'automate dont le fonctionnement est modélisé par un ensemble d'états reliés entre eux par des transitions. Une machine d'état finie comporte un nombre fini d'états. Le passage d'un état en cours à un état suivant relié à l'état en cours par une transition est effectué en fonction de variables d'état.

Classiquement, une machine d'état comporte des signaux d'entrée et des signaux de sortie élaborés à chaque transition en fonction des signaux d'entrée. Les signaux d'entrée et sortie d'une machine d'état peuvent également être répertoriés en signaux primaires et signaux secondaires. Les signaux d'entrée primaires sont les signaux que la machine d'état reçoit de l' ''extérieur''. Les signaux de sortie primaires sont les signaux que la machine d'état envoie vers l'extérieur. Les signaux de sortie secondaires produits par la machine d'état deviennent les signaux d'entrée secondaires lors de la transition suivante. Les signaux d'entrée secondaires renseignent la machine d'état sur l'état en cours.

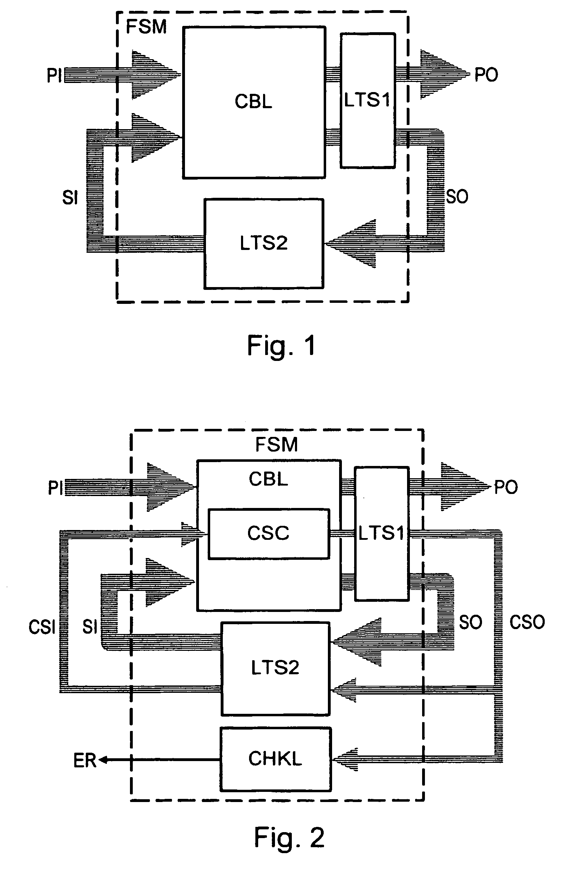

La figure 1 représente sous la forme de blocs une machine d'état. Sur la figure 1, la machine d'état FSM comprend un circuit de logique combinatoire CBL et des ensembles de verrous LTS1, LTS2. Toutes les sorties du circuit CBL sont connectées à l'ensemble de verrous LTS1. Le circuit CBL comporte des entrées primaires PI et des sorties primaires PO. Le circuit CBL comporte également des entrées secondaires SI et des sorties secondaires SO. Les sorties secondaires SO en sortie de l'ensemble LTS1 sont connectées à l'ensemble de verrous LTS2. Les verrous de l'ensemble LTS1 permettent de mémoriser l'état en cours de la machine d'état, c'est-à-dire les dernières valeurs des signaux de sortie primaires et secondaires élaborés par la machine d'état. Les signaux de sortie secondaires, une fois verrouillés par l'ensemble de verrous LTS2, deviennent les signaux d'entrée secondaires SI utilisés par le circuit CBL pour exécuter la transition suivante.

De nombreux circuits électroniques utilisent des machines d'état. C'est le cas notamment de certaines mémoires à accès série comme les mémoires EEPROM (Electrically Erasable Programmable Read-Only Memory).

Dans de telles applications, les transitions sont effectuées généralement en synchronisme avec un signal d'horloge fourni par un bus de communication. Les signaux d'entrée primaires comprennent généralement des signaux reçus par la mémoire, ainsi que d'autres signaux internes à la mémoire. Les signaux de sortie primaires sont des signaux de commande contrôlant divers sous-ensembles de la mémoire (registres à décalage, décodeurs du plan mémoire, circuiterie de lecture, pompe de charge, etc.).

Il s'avère qu'une fréquence d'horloge trop élevée peut gravement perturber le fonctionnement de la machine d'état. Cette perturbation se traduit généralement par la production de signaux de sortie erronés, avec pour conséquence un dysfonctionnement, voire un blocage de la machine d'état ou de l'ensemble dans lequel la machine d'état est intégrée. Dans le cas d'une mémoire, un dysfonctionnement peut se traduire par exemple par le décodage de commandes erronées, par la corruption de données en lecture (donc réversible) ou en écriture (irréversible), ou par le blocage de la mémoire, qui peut nécessiter une remise à zéro par coupure et reprise de l'alimentation.

Le déclenchement du dysfonctionnement peut être involontaire (par exemple bruit sur le signal d'horloge d'un bus d'accès, interprété comme un bref coup d'horloge), ou volontaire. Dans ce dernier cas, il peut s'agir de tentatives pour perturber le fonctionnement d'un circuit sécurisé, afin de tenter de violer une fonction de sécurisation. En effet, certaines mémoires EEPROM adaptées à une application spécifique comportent des fonctions de sécurisation dont le fonctionnement peut être plus ou moins lié à la machine d'état.

Pour détecter un tel dysfonctionnement, on a déjà proposé de déterminer la fréquence du signal d'horloge en mesurant la durée des périodes ou demi-périodes du signal d'horloge au moyen d'une référence de temps et de comparer la fréquence ainsi déterminée à un seuil de fréquence. Il s'avère que cette détection de dysfonctionnement est indépendante de la fréquence maximale de fonctionnement de la machine d'état. Pour être certain de se prémunir contre un dysfonctionnement de la machine d'état, il est nécessaire de définir un seuil de fréquence bien inférieur au seuil réel de dysfonctionnement de la machine d'état. En effet, selon les variations de tension d'alimentation, de température, et de paramètres de fabrication, la fréquence de la référence de temps et la fréquence maximale de fonctionnement de la machine d'état varient de façon décorrélée. Un signal d'erreur doit donc être généré au delà d'un seuil bien inférieur à la fréquence maximale de fonctionnement. Il en résulte que la marge de sécurité nécessaire entraîne une réduction de la fréquence maximale de fonctionnement du circuit. Typiquement, le seuil de détection d'un dysfonctionnement est fixé à une fréquence au moins deux fois plus faible que la fréquence maximale de fonctionnement de la machine d'état.

Le document "VHDL-Based Design of FSM with Concurrent Error Detection Capability", M. K. Stojcev et al., Proc. 24th International Conference on Microelectronics (MIEL 2004), Vol. 2, NIS, Serbia and Montenegro, 16-19 May 2004, décrit une machine d'état dans laquelle une détection d'erreur est effectuée à l'aide d'une réplique de la machine d'état en comparant les sorties respectives des deux machines d'état.

Le but de l'invention est de réduire la marge de sécurité sur la fréquence de fonctionnement d'une machine d'état à une valeur minimum.

Un autre but de l'invention est de détecter de manière précise un risque de dysfonctionnement de la machine d'état, lié à une anomalie sur le signal d'horloge.

2

A cet effet, une idée de l'invention est de détecter des conditions de dysfonctionnement directement à partir du fonctionnement de la machine d'état.

Plus particulièrement, l'invention prévoit un procédé de détection d'un dysfonctionnement dans une machine d'état ayant un fonctionnement modélisé par un ensemble d'états reliés entre eux par des transitions, la machine d'état élaborant à chaque transition des signaux de sortie en fonction de signaux d'entrée comprenant des signaux élaborés lors d'une transition précédente.

Selon l'invention, le procédé comprend des étapes consistant à :

- définir dans la machine d'état un circuit de traitement pour élaborer au moins un signal de contrôle en fonction d'un signal de contrôle élaboré lors d'une transition précédente,
- élaborer par le circuit de traitement durant une transition le signal de contrôle en fonction d'un signal de contrôle élaboré lors d'une transition précédente par le circuit de traitement,
- déterminer durant la transition une valeur attendue de chaque signal de contrôle, et
- comparer chaque signal de contrôle élaboré avec la valeur attendue.

Selon un mode de réalisation de l'invention, le procédé comprend des étapes d'élaboration de deux signaux logiques de contrôle qui sont inverses l'un de l'autre et inversés à chaque transition de la machine d'état.

Selon un mode de réalisation de l'invention, les signaux logiques de contrôle D1, D2 sont obtenus par les opérations logiques suivantes :

$$D1 = N[C1].C2,$$

$$D2 = C1.N[C2]$$

dans lesquelles C1 et C2 sont les signaux logiques de contrôle obtenus lors d'une transition précédente, N[x] représente l'opération logique d'inversion appliquée au signal x, et "." représente l'opération logique ET.

Selon un mode de réalisation de l'invention, le procédé comprend une étape de génération d'un signal d'erreur en fonction du résultat de l'étape de comparaison.

Selon un mode de réalisation de l'invention, l'élaboration des signaux de contrôle est ralentie.

L'invention concerne également une machine d'état ayant un fonctionnement modélisé par un ensemble d'états reliés entre eux par des transitions, et élaborant à chaque transition des signaux de sortie en fonction de signaux d'entrée comprenant des signaux élaborés lors d'une transition précédente,

Selon l'invention, la machine d'état comprend un circuit de traitement pour élaborer au moins un signal de contrôle durant une transition de la machine d'état, en fonction d'un signal de contrôle élaboré par le circuit de traitement lors d'une transition précédente, et un circuit de contrôle pour déterminer une valeur attendue de chaque signal de contrôle et comparer le signal de contrôle avec la valeur attendue.

Selon un mode de réalisation de l'invention, le circuit de traitement élabore deux signaux logiques de contrôle qui sont inverses l'un de l'autre et inversés à chaque transition de la machine d'état.

Selon un mode de réalisation de l'invention, le circuit de traitement met en oeuvre les opérations logiques suivantes :

$$D1 = N[C1].C2,$$

$$D2 = N[C2]$$

dans lesquelles D1 et D2 sont les signaux logiques de contrôle élaborés lors d'une transition en cours, C1 et C2 sont les signaux logiques de contrôle obtenus lors d'une transition précédente, N[x] représente l'opération logique d'inversion appliquée au signal x, et "." représente l'opération logique ET.

Selon un mode de réalisation de l'invention, le circuit de contrôle élabore un signal d'erreur en fonction de la comparaison du signal de contrôle avec la valeur attendue.

Selon un mode de réalisation de l'invention, la machine d'état comporte un réseau logique programmable comprenant des inverseurs d'entrée, des circuits logiques produit, des circuits logiques somme, et des moyens de configuration pour connecter sélectivement des entrées de la machine d'état et des sorties des inverseurs d'entrée à des circuits logiques produit, et pour connecter sélectivement des sorties des circuits logiques produit à des entrées de circuits logiques somme, le circuit de traitement comprenant pour chaque signal logique de contrôle un circuit logique produit connecté à un circuit logique somme fournissant le signal logique de contrôle.

Selon un mode de réalisation de l'invention, les circuits logiques produit et les circuits logiques somme fournissant les signaux logiques de contrôle sont configurés pour que la génération des signaux logiques de contrôle soit ralentie.

Ces objets, caractéristiques et avantages ainsi que d'autres de la présente invention seront exposés plus en détail dans la description suivante d'un mode de réalisation de l'invention, faite à titre non limitatif en relation avec les figures jointes parmi lesquelles :

- la figure 1 déjà décrite représente sous la forme de blocs une machine d'état selon l'art antérieur,
- la figure 2 représente sous la forme de blocs une machine d'état selon l'invention,
- la figure 3 représente sous la forme de blocs un mode de réalisation de la machine d'état selon l'invention,
- la figure 4 représente sous la forme de blocs un mode de réalisation d'un circuit de logique combinatoire de la machine d'état illustrée par la figure 3,
- les figures 5 à 8 sont des circuits électriques de blocs du circuit de logique combinatoire représenté sur la figure 4,
- la figure 9 illustre sous la forme de chronogrammes le fonctionnement du circuit représenté sur la figure 8,
- la figure 10 est un schéma électrique d'un circuit de génération de signaux secondaires de contrôle, du circuit de logique combinatoire,
- la figure 11 est un schéma électrique d'un circuit de détection d'erreur de la machine d'état représentée sur la figure 3,
- la figure 12 illustre sous la forme de chronogrammes le fonctionnement du circuit de détection d'erreur représenté sur la figure 11.

La figure 2 représente une machine d'état selon l'invention. Sur la figure 2, la machine d'état FSM comprend un circuit de logique combinatoire CBL et des ensembles de verrous LTS1, LTS2. Toutes les sorties du circuit CBL sont connectées à l'ensemble de verrous LTS1. Le circuit CBL comporte des entrées primaires PI et des sorties primaires PO. Le circuit CBL comporte également des entrées secondaires SI et des sorties secondaires SO. Les sorties secondaires SO en sortie de l'ensemble LTS1 sont connectées à l'ensemble de verrous LTS2. Les verrous de l'ensemble LTS1 permettent de mémoriser les états de la machine d'état, c'est-à-dire les valeurs des signaux de sortie primaires et secondaires élaborés par la machine d'état. Les signaux de sortie secondaires SO, une fois verrouillés par l'ensemble de verrous LTS2, deviennent les signaux d'entrée secondaires SI utilisés par le circuit CBL pour exécuter la transition suivante.

Selon l'invention, le circuit CBL comprend un circuit de contrôle CSC fournissant des signaux de sortie secondaires de contrôle CSO qui sont appliqués à l'ensemble de verrous LTS1, puis à l'ensemble de verrous LTS2. Un fois verrouillés par l'ensemble LTS2, les signaux CSO deviennent des signaux d'entrée secondaires de contrôle CSI qui sont appliqués en entrée du circuit CSC.

La machine d'état FSM selon l'invention comprend également un circuit de vérification CHKL qui reçoit les signaux de sortie secondaires de contrôle CSO, et qui élabore un signal d'erreur ER en fonction de la valeur de chacun des signaux CSO. Le signal d'erreur est par exemple élaboré en comparant les signaux CSO à des valeurs attendues.

Lorsque le signal ER indique qu'une erreur a été détectée, plusieurs actions peuvent être effectuées selon l'application de la machine d'état FSM. Ainsi, le signal ER peut être utilisé pour réinitialiser de tout ou partie du composant dans lequel la machine d'état est intégrée. Le signal ER peut également être fourni à l'extérieur du composant pour signaler l'erreur à des organes externes au composant.

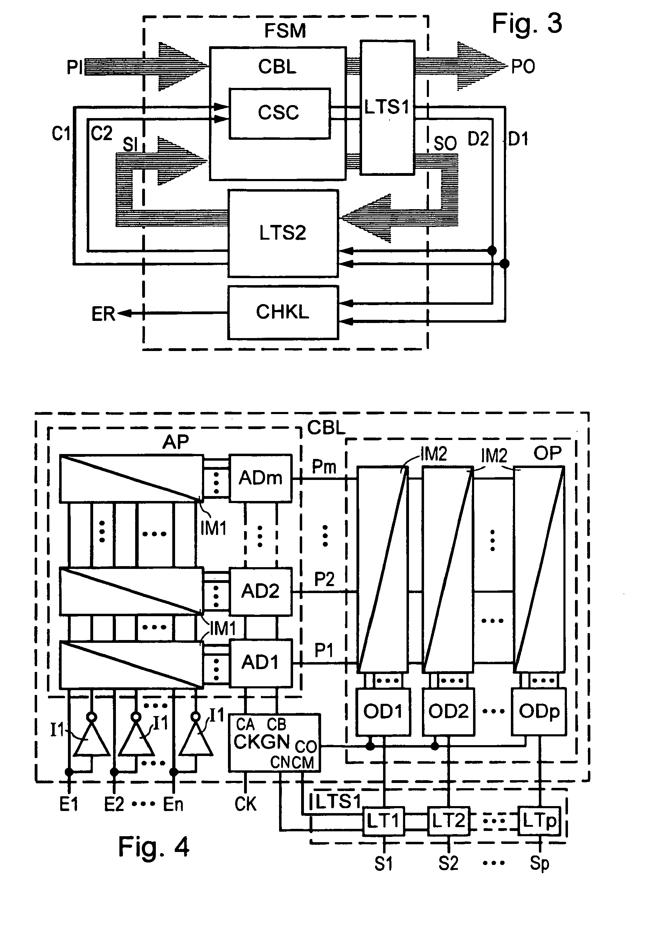

La figure 3 représente un mode de réalisation particulier de la machine d'état FSM illustrée sur la figure 2. Sur la figure 3, les signaux de sortie secondaires de contrôle CSO fournies par le circuit de contrôle CSC, en sortie de l'ensemble de verrous LTS1, comprennent deux signaux D1, D2 qui deviennent des signaux C1, C2 en sortie des verrous LTS2.

La figure 4 représente un mode de réalisation du circuit de logique combinatoire CBL. Sur la figure 4, le circuit CBL reçoit des signaux d'entrée E1, E2, ... En et fournit des signaux de sortie S1, S2, ... Sp résultant de l'application de fonctions logiques aux signaux E1, E2, ... En. Le circuit CBL est réalisé à l'aide d'un réseau logique programmable PLA (Programmable Logic Array) qui reçoit les signaux d'entrée E1-En, et qui fournit les signaux de sortie S1-Sp. Les signaux S1-Sp sont de façon déterminée la somme de produits des signaux E1-En.

Classiquement, le réseau logique programmable du circuit CBL comprend un étage d'entrée AP, également appelé "plan ET" appliquant la fonction logique ET ou produit aux signaux d'entrée E1-En, et un étage de sortie OP, également appelé "plan OU" appliquant la fonction OU ou somme aux signaux de sortie P1, P2, ...Pm de l'étage AP.

Le réseau logique programmable comprend des inverseurs I1 recevant les signaux d'entrée E1-En et dont les sorties sont connectées à des entrées de l'étage d'entrée AP. Les sorties du réseau logique programmable constituées par les sorties de l'étage de sortie OP sont connectées à des verrous de sortie LT1, LT2, ... LTp de l'ensemble LTS1, qui mémorisent chacun un signal de sortie S1-Sp du circuit CBL. Le réseau logique programmable comprend un circuit de génération de signaux d'horloge CKGN cadençant les étages d'entrée AP et de sortie OP, ainsi que les verrous LT1-LTp.

L'étage d'entrée AP du circuit CBL comprend plusieurs circuits logiques produit AD1, AD2, ... ADm réalisant chacun une fonction logique ET à plusieurs entrées et une sortie P1, P2, ..., Pm, et des matrices d'interconnexion IM1 connectant chacune sélectivement certaines entrées de l'étage d'entrée AD regroupant les entrées E1-En du circuit CBL et les entrées inversées de ces dernières, à certaines entrées d'un des circuits logiques produit AD1-ADm. Ainsi, si le circuit CBL comporte n entrées E1-En, et si chaque circuit AD1-ADm comporte au maximum q entrées, chaque matrice d'interconnexion IM1 comprend 2n entrées et q sorties. Généralement, le nombre q d'entrées de chaque circuit produit est au maximum égal au nombre n d'entrées du réseau logique programmable. Les sorties P1-Pm des circuits AD1-ADm constituent les sorties de l'étage d'entrée AP.

L'étage de sortie OP du circuit CBL comprend plusieurs circuits logiques somme OD1, OD2, ... ODp réalisant chacun une fonction OU ou somme, à plusieurs entrées et une sortie, et des matrices d'interconnexion IM2 connectant chacune sélectivement certaines sorties P1-Pm de l'étage d'entrée AD à certaines entrées d'un des circuits logiques produit OD1-ODp. Si le circuit CBL comporte m circuits AD1-ADm, et si chaque circuit logique somme OD1-ODp comporte au maximum r entrées, chaque matrice d'interconnexion IM2 comprend m entrées et r sorties. En général le nombre r d'entrées des circuits somme est inférieur au nombre m de circuits somme. Les sorties des circuits OD1-ODp constituent les sorties de l'étage de sortie OP et sont connectées chacune à l'entrée d'un verrou LT1-LTp.

La configuration des matrices d'interconnexion IM1, IM2 détermine la fonction logique réalisée par le circuit CBL.

Dans la description qui suit, les références commençant par "MN" sont utilisées pour désigner un transistor MOS à canal N et les référence commençant par "MP" sont utilisées pour désigner un transistor MOS à canal P.

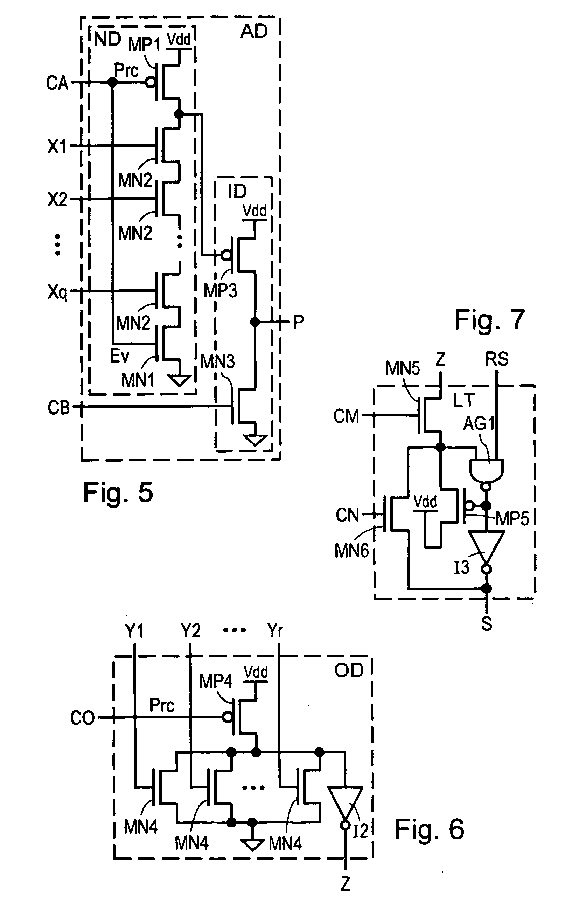

La figure 5 est un schéma électrique d'un circuit logique produit AD de l'étage d'entrée AP. Sur la figure 5, le circuit AD comprend une branche d'entrée ND réalisant une fonction logique ET inversée dynamique, et une branche de sortie ID réalisant la fonction d'un inverseur dynamique, dont la sortie constitue une sortie P du circuit AD.

La branche d'entrée ND du circuit AD comprend un groupe de plusieurs transistors MN2 agencés en série. La grille de chaque transistor MN2 est connectée à une entrée X1-Xq du circuit AD. Le groupe de transistors MN2 comprend un premier transistor MN2 dont la grille est connectée à une première entrée X1 du circuit AD, et dont le drain est connecté au drain d'un transistor MP1. La grille du transistor MP1 reçoit un signal d'horloge CA, et le drain de ce transistor reçoit une tension d'alimentation Vdd. Le transistor MP1 assure la précharge des transistors MN2. Le groupe de transistors MN2 comprend un dernier transistor MN2 dont la grille est connectée à une dernière entrée Xq du circuit AD, et dont la source est connectée au drain d'un transistor MN1. La grille du transistor MN1 reçoit le signal d'horloge CA, et la source de ce transistor est connectée à la masse. Le noeud de connexion du drain du transistor MP1 au drain du premier transistor MN2 constitue la sortie de la fonction logique ET inversée dynamique. Le transistor MN1 permet l'évaluation de la fonction logique ET inversée dynamique réalisée par les transistors MN2, à la suite de la précharge de ces derniers. Le signal d'horloge CA détermine des phases de précharge (CA = 0) et d'évaluation (CA = 1) de la branche d'entrée ND du circuit AD.

La branche de sortie ID du circuit AD comprend un transistor MP3 dont la grille est connectée à la sortie de la branche d'entrée ND, c'est-à-dire au drain du transistor MP1 et au drain du premier transistor MN2. La source du transistor MP3 reçoit la tension d'alimentation Vdd. La branche de sortie ID comprend un transistor MN3 dont la grille reçoit un signal d'horloge CB, dont la source est à la masse et dont le drain est connecté au drain du transistor MP3 et à la sortie P du circuit AD.

Le transistor MN3 permet la précharge, puis l'évaluation de la fonction logique d'inversion dynamique réalisé par le transistor MP3. Le signal d'horloge CB détermine des phases de précharge (CB = 1) et d'évaluation (CB = 0) de la branche de sortie ID du circuit AD.

La figure 6 est le schéma électrique d'un circuit logique somme OD de l'étage de sortie OP. Sur la figure 6, le circuit OD comprend plusieurs transistors MN4 agencés en parallèle, dont la source est connectée à la masse. La grille de chacun des transistors MN4 est connectée à une entrée Y1-Yr du circuit OD. Le drain des transistors MN4 est connecté au drain d'un transistor MP4 dont la source reçoit la tension d'alimentation Vdd, et dont la grille reçoit un signal d'horloge CO. Les transistors MN4 réalisent une fonction OU inversée dynamique, le drain de chacun des transistors MN4 constituant la sortie de la fonction et étant connecté à l'entrée d'un inverseur I2. La sortie de l'inverseur I2 fournit le signal de sortie Z du circuit OD.

Le transistor MP4 permet l'évaluation de la fonction logique OU inversée dynamique réalisée par les transistors MN4, à la suite de la précharge de ces derniers. Le signal d'horloge CO commandant le transistor MP4 détermine des phases de précharge (CO = 0) et d'évaluation (CO = 1) du circuit OD.

La figure 7 est le schéma électrique d'un verrou LT identique aux verrous LT1-LTp de l'ensemble de verrous LTS1. Le verrou LT comprend un transistor MN5 dont le drain reçoit le signal de sortie Z d'un circuit logique produit OD, et dont la grille reçoit un signal d'horloge CM. La source du transistor MN5 est connectée à l'entrée d'une porte logique AG1 de type ET inversée, à la source d'un transistor MN6 dont la grille reçoit un signal d'horloge CN, ainsi qu'au drain d'un transistor MP6 dont la source reçoit la tension d'alimentation Vdd. Une autre entrée de la porte AG1 reçoit un signal d'initialisation RS. La sortie de la porte AG1 est connectée à la grille du transistor MP6, et à l'entrée d'un inverseur I3 dont la sortie constitue une sortie S du verrou LT et est connectée au drain du transistor MN6.

Les signaux d'horloge CM et CN déterminent des phases de charge (CM = 1, CN = 0) et de verrouillage (CM = 0, CN = 1) du verrou LT. , Le verrou LT à l'état verrouillé (signaux CM et CN respectivement à 0 et 1) peut être initialisé à 0 en passant le signal d'initialisation RS à 0. Le transistor MP6 permet d'éviter une surconsommation du verrou en évitant les fuites. En effet, lorsque le transistor MN5 est passant, il ne laisse pas passer la tension Vdd mais Vdd - VtN sur l'entrée de la porte AG1 (VtN étant la tension de seuil des transistors MOS à canal N). La tension Vdd - VtN est suffisante pour faire basculer la porte AG1, mais le transistor MOS à canal P à l'entrée de la porte AG1 connectée au transistor MN5 risque de fuir. La présence du transistor MP6 permet de remonter à Vdd la tension à l'entrée de la porte AGI, si cette dernière a basculé.

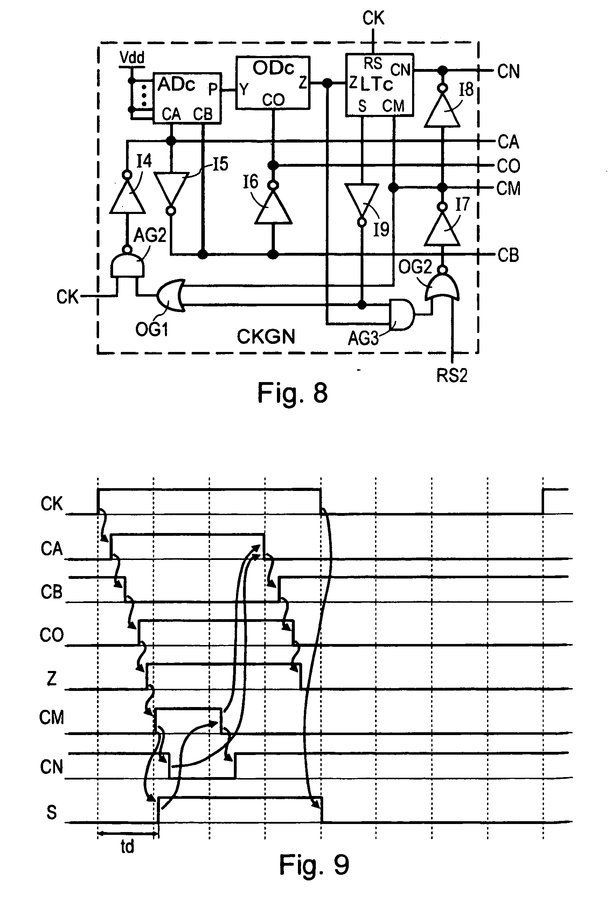

La figure 8 est un schéma électrique du circuit de génération de signaux d'horloge CKGN du circuit CBL. Le circuit CKGN utilise un circuit logique produit ADc, un circuit logique somme ODc et un verrou LTc du réseau logique programmable constituant le circuit CBL. La sortie P du circuit ADc est connectée à l'entrée Y du circuit ODc. La sortie Z du circuit ODc est connectée à l'entrée Z du verrou LTc. L'entrée d'initialisation du verrou LTc reçoit en tant que signal d'initialisation le signal d'horloge CK. Toutes les entrées X1-Xq du circuit ADc sont connectées à la source de tension d'alimentation Vdd.

Le circuit CKGN comprend une porte logique AG2 de type ET inversée recevant un signal d'horloge primaire CK. La sortie de la porte AG2 est connectée à l'entrée d'un inverseur I4 dont la sortie fournit le signal d'horloge CA qui est appliqué aux circuits produit ADc, AD1-ADm de l'étage d'entrée AP, incluant le circuit produit ADc du circuit CKGN.

Le circuit CKGN comprend un inverseur I5 recevant le signal d'horloge CA et fournissant le signal d'horloge CB également appliqué aux circuits produit AD1-ADm et ADc. Le circuit CKGN comprend un inverseur I6 recevant le signal d'horloge CB et fournissant le signal d'horloge CO appliqué aux circuits somme ODc, OD1-ODp de l'étage de sortie OP, incluant le circuit somme ODc du circuit CKGN.

Le circuit CKGN comprend une porte logique AG3 de type ET dont une entrée est connectée à la sortie Z du circuit ODc et dont la sortie est connectée à l'entrée d'une porte logique OG2 de type OU inversée. Une autre entrée de la porte OG2 reçoit un signal d'initialisation RS2 et la sortie de cette porte est connectée à l'entrée d'un inverseur I7 dont la sortie fournit le signal d'horloge CM qui est appliqué au verrou LTc et à une entrée d'une porte logique OG1 de type OU.

Le circuit CKGN comprend un inverseur I8 recevant le signal d'horloge CM et fournissant le signal d'horloge CN appliqué aux verrous LTc et LT1-LTp. La sortie S du verrou LTc est connectée à l'entrée d'un inverseur I9 dont la sortie est connectée à une entrée de la porte AG3 et à une entrée de la porte OG1.

La figure 9 illustre sous la forme de chronogrammes le fonctionnement du circuit de génération de signaux d'horloge CKGN. La figure 9 représente les chronogrammes des signaux d'horloge CK, CA, CB, CO, CM et CN, du signal de sortie Z du circuit ODc et du signal de sortie S du verrou LTc du circuit CKGN. Dans un état initial, les signaux d'horloge CA, CO, et CM, le signal de sortie Z du circuit ODc et le signal de sortie S du verrou LTc sont égaux à 0, tandis que les signaux d'horloge CB et CN sont égaux à 1. Il en résulte que la précharge de l'étage d'entrée AP et de l'étage de sortie OP démarre.

A l'arrivée d'un front montant du signal d'horloge primaire CK, à l'état initial du circuit CKGN, le signal d'horloge CA passe à 1, marquant la fin de la précharge de l'étage d'entrée AP et donc le début de l'évaluation des branches d'entrée ND de l'étage d'entrée. A la fin de la précharge de l'étage d'entrée AP, le signal d'horloge CB en sortie de l'inverseur I5 passe alors à 0. Les sorties P1-Pm de l'étage d'entrée AP sont alors valides. En fait, les sorties P1-Pm ne sont valides qu'un certain temps après le début de l'évaluation de l'étage d'entrée en raison du temps de propagation des signaux d'entrée E1-En dans les branches d'entrée ND. Pour être certain que ce temps de propagation est terminé, et donc que les sorties P1-Pm de l'étage d'entrée AD sont valides, le circuit ADc du circuit CKGN comporte un nombre d'entrées supérieur au nombre n d'entrées E1-En du circuit CBL, c'est-à-dire au nombre q d'entrées de chaque circuit AD1-ADp. Le circuit ADc est ainsi le plus lent à fournir un signal de sortie P valide, de tous les circuits produit AD1-ADm, ADc du circuit CBL.

Lorsque la sortie du circuit ADc bascule, le signal CO passe à 1, et la précharge de l'étage de sortie OP est arrêtée. Le signal de sortie P du circuit produit ADc du circuit CKGN passe alors à 1. Pour déterminer quand les sorties de l'étage de sortie OP sont valides, la sortie P du circuit ADc est appliquée à une entrée du circuit somme ODc du circuit CKGN. Le nombre d'entrées du circuit ODc est choisi supérieur au nombre total de circuits ADc, AD1-ADp utilisés, une entrée Y du circuit ODc étant connectée à la sortie P du circuit ADc et toutes les autres entrées du circuit ODc sont à la masse. De cette manière, lorsque la sortie Z du circuit ODc bascule, on est certain que toutes les sorties Z1-Zp des circuits OD1-ODp ont eu le temps de basculer. Après un certain temps nécessaire à la propagation des signaux dans l'étage de sortie OP, les sorties Z des circuits somme ODc, OD1-ODp basculent.

Les deux entrées de la porte AG3 sont alors à 1. Il en résulte que le signal d'horloge CM passe à 1. Le passage à 1 du signal d'horloge CM entraîne le passage à 0 du signal d'horloge CN au travers de l'inverseur I8 et un changement d'état de la sortie S du verrou LT du circuit CKGN qui passe à 1. Le changement d'état de la sortie S du verrou LT entraîne le passage à 0 du signal d'horloge CM, puis le passage à 1 du signal d'horloge CN. Les signaux de sortie Z, Z1-Zp des circuits ODc, OD1-ODp sont ainsi verrouillés par les verrous LTc, LT1-LTp dès qu'ils sont valides. Le signal CA passe alors à 0 par l'intermédiaire des portes OG1, AG2 et de l'inverseur I4. Le passage à 0 du signal CA entraîne le passage à 1 du signal CB, puis le passage à 0 du signal CO, et enfin le passage à 0 du signal de sortie Z du circuit ODc. La phase d'évaluation des étages d'entrée AP et de sortie OP est donc arrêtée, pour redémarrer une nouvelle phase de précharge des étages d'entrée AP et de sortie OP. Au front descendant du signal d'horloge primaire CK qui initialise le verrou LTc, le signal de sortie S de ce verrou repasse à 0.

Pendant la nouvelle phase de précharge, les signaux d'entrée E1-En prennent une nouvelle valeur correspondant à un nouvel état d'entrée de la machine d'état FSM. Ensuite, le processus décrit précédemment recommence pour exécuter une nouvelle transition de la machine d'état.

Il est à noter que pour que la machine d'état fonctionne correctement, il faut que toutes les entrées E1-En soient stables un peu avant la montée du signal d'horloge CK, jusqu'à au moins la descente de du signal d'horloge CM.

Sur la figure 9, il apparaît que le dernier événement avant l'arrivée du front descendant du signal d'horloge primaire CK est le passage à 0 du signal d'horloge CO. Si le front descendant du signal CK apparaît avant la retombée du signal CO, en raison d'une perturbation fortuite ou volontaire, le fonctionnement du circuit CKGN sera perturbé et va générer des signaux d'horloge CA, CB, CO, CM, CN ne permettant pas de synchroniser correctement les circuits produit AD, les circuits somme OD et les verrous LT du circuit CBL. Le circuit CBL va donc générer des signaux erronés.

En ajoutant les signaux secondaires de contrôle C1, C2, D1, D2 dont les valeurs sont prévisibles, l'invention vise à détecter un tel fonctionnement erroné du circuit CBL.

Avantageusement, les matrices de connexion IM1 et IM2 sont configurées pour élaborer les signaux secondaires de sortie de contrôle D1, D2 en appliquant les opérations logiques suivantes aux signaux secondaires d'entrée de contrôle C1, C2 :

$$D1 = N[C1].C2, \qquad\qquad (1)$$

$$D2 = C1.N[C2] \qquad\qquad (2)$$

dans lesquelles N[x] représente l'opération logique d'inversion (NOT) appliquée au signal x, et "." représente l'opération logique ET.

De cette manière, les signaux D1 et D2 permettent de détecter des passages erronés à 0 et à 1 de signaux internes au circuit CBL.

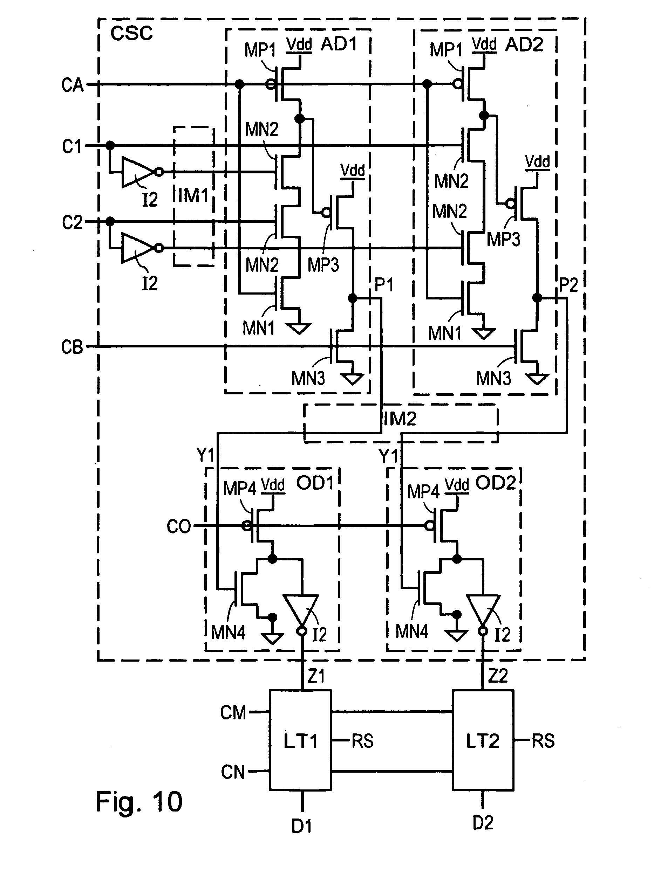

Selon un mode de réalisation de l'invention illustré sur la figure 10, le circuit de contrôle CSC est réalisé à l'aide de deux circuits produit AD1, AD2 et deux circuits somme OD1, OD2 du circuit CBL, pour élaborer les signaux D1, D2 en fonction des signaux C1, C2, conformément aux opérations logiques (1) et (2). Les transistors MN2, MN4 dont la grille n'est pas connectée n'ont pas été représentés sur la figure 10.

Pour réaliser l'opération logique (1), une matrice d'interconnexion IM1 est configurée pour appliquer sur des entrées du premier circuit produit AD1 le signal C1 préalablement inversé par un inverseur I1, et le signal C2. Les autres entrées du circuit AD1 ne sont pas connectées. Une matrice d'interconnexion IM2 est configurée pour connecter la sortie P1 du circuit AD1 à une entrée Y1 du premier circuit somme OD1 dont les autres entrées ne sont pas connectées.

De même, pour réaliser l'opération logique (2), une matrice d'interconnexion IM1 est configurée pour appliquer sur des entrées du second circuit produit AD2 le signal C1 et le signal C2 préalablement inversé par un inverseur I1. Les autres entrées du circuit AD2 ne sont pas connectées. Une matrice d'interconnexion IM2 est configurée pour connecter la sortie P2 du circuit AD2 à une entrée Y1 du second circuit somme OD2 dont les autres entrées ne sont pas connectées.

Les verrous LT1, LT2 connectés aux sorties Z1, Z2 des circuits somme OD1, OD2 sont initialisés respectivement à 0 et 1 ou inversement. Il en résulte que les signaux D1 et D2 en sortie des verrous LT1, LT2 changent d'état à chaque transition de la machine d'état FSM et sont toujours de valeurs différentes.

Le verrou LT2 fournissant le signal D2 est différent des autres verrous de l'ensemble LTS1 pour pouvoir être initialisé à 1. A cet effet, la porte AG1 du verrou LT représenté sur la figure 7 est remplacée par une porte OU inversée dont une entrée peut recevoir un signal de commande d'initialisation à 1.

Pour la génération des signaux P1 et P2, les circuits produit AD1, AD2 comportent avantageusement plusieurs transistors MN2 supplémentaires, dont la grille est connectée à la source de tension d'alimentation Vdd. De préférence, le nombre total de transistors MN2 de chacun des circuits AD1, AD2 est égal au nombre maximal q de transistors rencontrés dans un circuit produit parmi tous les circuits produit AD1-ADm du circuit CBL.

De même, pour la génération des signaux de sortie Z1 et Z2, les circuits somme OD1, OD2 comportent avantageusement plusieurs transistors MN4 supplémentaires dont la grille est connectée à la masse. De préférence, le nombre total de transistors MN4 de chacun des circuits OD1, OD2 est égal au nombre maximal r de transistors MN4 rencontrés dans un circuit somme parmi tous les circuits somme OD1-ODp du circuit CBL.

De cette manière, la génération des signaux D1 et D2 est ralentie le plus possible. Il en résulte qu'un risque de dysfonctionnement est détecté de façon plus fine.

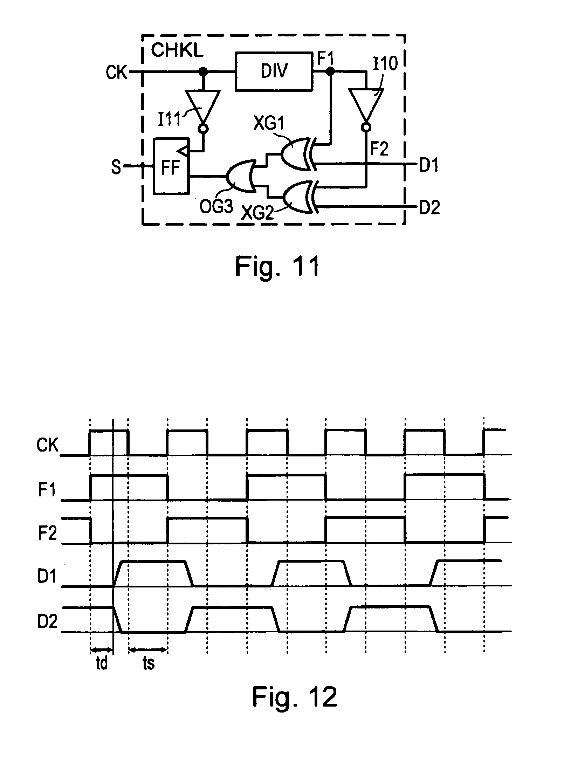

La figure 11 est un schéma électrique du circuit de vérification CHKL. Le circuit CHKL comprend un diviseur de fréquence par 2 DIV recevant en entrée le signal d'horloge primaire CK et fournissant un signal de contrôle F1 dont la fréquence est égale à la moitié de celle du signal CK. Le diviseur DIV est par exemple réalisé à l'aide d'un compteur à un seul étage. Le signal de contrôle F1 est appliqué à l'entrée d'un inverseur I10 et à une entrée d'une porte logique XG1 de type OU EXCLUSIF dont une autre entrée reçoit le signal de sortie secondaire de contrôle D1. La sortie de l'inverseur I10 fournit un second signal de contrôle F2 qui est appliqué à une entrée d'une porte logique XG2 de type OU EXCLUSIF dont une autre entrée reçoit le signal de sortie secondaire de contrôle D2. La sortie de chaque porte XG1, XG2 est connectée à une entrée d'une porte logique OG3 de type OU, dont la sortie est connectée à l'entrée d'une bascule FF (flip-flop) de type D, c'est-à-dire déclenchée sur front du signal d'horloge.

Le circuit CHKL comprend un inverseur I11 recevant en entrée le signal d'horloge primaire CK et dont la sortie est connectée à une entrée de signal d'horloge de la bascule FF. La sortie de la bascule FF fournit le signal de sortie ER du circuit CHKL. Du point de vue logique, la bascule FF assure une fonction équivalente à une porte logique ET.

Le circuit CHKL réalise la fonction logique suivante:

$$ER = (D1 \oplus F1 + D2 \oplus F2).N[CK] \qquad (3)$$

dans laquelle "$\oplus$" représente l'opération logique OU EXCLUSIF, et "+" représente l'opération logique OU. En d'autres termes, le signal ER passe à 1 indique qu'une erreur a été détectée (ER = 1) si les signaux D1 et F1 sont différents ou les signaux D2 et F2 sont différents lorsque le signal d'horloge CK est à 0.

Le fonctionnement du circuit CHKL est illustré par les chronogrammes représentés sur la figure 12. La figure 12 représente les chronogrammes des signaux d'horloge primaire CK et des signaux de contrôle F1, F2, D1 et D2. Les signaux F1 en sortie du diviseur DIV et F2 en sortie de l'inverseur I10 changent d'état à chaque front montant du signal d'horloge CK et sont en opposition de phase. Les signaux D1 et D2 présentent la même fréquence que les signaux F1 et F2 et sont également en opposition de phase. Les signaux F1 et D1 sont déphasés d'une durée td. Il en est de même pour les signaux F2 et D2. La durée td correspond au temps de décodage effectué par le circuit CBL, c'est-à-dire au temps entre le passage à 1 du signal d'horloge CK et le passage à 1 du signal S en sortie du verrou LTc. En raison de la présence de la bascule FF, les périodes ts où le signal d'horloge CK est à 0 définissent les périodes où le signal de sortie ER du circuit CHKL peut être évalué, c'est-à-dire peut passer à 1 en raison d'une différence détectée entre les signaux D1 et/ou D2 et les signaux F1 et/ou F2.

Bien entendu, l'invention est susceptible de diverses variantes et applications. Ainsi, l'invention n'est pas limitée aux machines d'état réalisées à l'aide d'un réseau logique programmable . Pour qu'un dysfonctionnement de la machine d'état puisse être détecté, il importe simplement que les signaux de contrôle soient élaborés par la machine d'état.

Il n'est pas nécessaire que les signaux de contrôles soient élaborés à chaque transition de la machine d'état. Ainsi, les signaux de contrôle peuvent être élaborés uniquement pendant certaines phases critiques de traitements effectués par la machine d'état.

Le nombre de signaux de contrôle élaborés à chaque transition n'est pas nécessairement égal à 2. Un seul ou plus de deux signaux de contrôle peuvent élaborés pour détecter un dysfonctionnement d'une machine d'état. L'usage de deux signaux de contrôle de valeurs opposées et qui changent d'état à chaque transition permet simplement d'optimiser le nombre de type d'erreurs détectées et le nombre de signaux supplémentaires prévus pour contrôler le fonctionnement de la machine d'état.

L'invention ne s'applique pas uniquement aux mémoires EEPROM. Elle s'applique à tout dispositif comportant une machine d'état.

## Revendications

**1.** Procédé de détection d'un dysfonctionnement dans une machine d'état (FSM) ayant un fonctionnement modélisé par un ensemble d'états reliés entre eux par des transitions, la machine d'état élaborant à chaque transition des signaux de sortie (PO, SO) en fonction de signaux d'entrée (PI, SI) comprenant des signaux (PI) élaborés lors d'une transition précédente,

**caractérisé en ce qu'**il comprend des étapes consistant à :

- définir dans la machine d'état un circuit de traitement (CSC) pour élaborer au moins un signal de contrôle (CSO) en fonction d'un signal de contrôle (CSI) élaboré lors d'une transition précédente,
- élaborer par le circuit de traitement durant une transition le signal de contrôle (CSO) en fonction d'un signal de contrôle (CSI) élaboré par le circuit de traitement lors d'une transition précédente,
- déterminer durant la transition une valeur attendue de chaque signal de contrôle (F1, F2), et
- comparer chaque signal de contrôle élaboré avec la valeur attendue.

2. Procédé selon la revendication 1, comprenant des étapes d'élaboration de deux signaux logiques de contrôle (D1, D2) qui sont inverses l'un de l'autre et inversés à chaque transition de la machine d'état (F5M).

3. Procédé selon la revendication 2, dans lequel les signaux logiques de contrôle D1, D2 sont obtenus par les opérations logiques suivantes :

$$D1 = N[C1].C2,$$

$$D2 = C1.N[C2]$$

dans lesquelles C1 et C2 sont les signaux logiques de contrôle obtenus lors d'une transition précédente, N[x] représente l'opération logique d'inversion appliquée au signal x, et "." représente l'opération logique ET.

4. Procédé selon l'une des revendications 1 à 3, comprenant une étape de génération d'un signal d'erreur (ER) en fonction du résultat de l'étape de comparaison.

5. Procédé selon l'une des revendications 1 à 4, dans lequel l'élaboration des signaux de contrôle (D1, D2) est ralentie.

6. Machine d'état (FSM) ayant un fonctionnement modélisé par un ensemble d'états reliés entre eux par des transitions, et élaborant à chaque transition des signaux de sortie (PO, SO) en fonction de signaux d'entrée (PI, SI) comprenant des signaux (PI) élaborés lors d'une transition précédente,
**caractérisée en ce qu'**elle comprend un circuit de traitement (CSC) pour élaborer au moins un signal de contrôle (D1, D2) durant une transition de la machine d'état, en fonction d'un signal de contrôle (C1, C2) élaboré par le circuit de traitement lors d'une transition précédente, et un circuit de contrôle (CHKL) pour déterminer une valeur attendue de chaque signal de contrôle (F1, F2) et comparer le signal de contrôle avec la valeur attendue.

7. Machine d'état selon la revendication 6, dans laquelle le circuit de traitement (CSC) élabore deux signaux logiques de contrôle (D1, D2) qui sont inverses l'un de l'autre et inversés à chaque transition de la machine d'état (FSM).

8. Machine d'état selon la revendication 6 ou 7, dans laquelle le circuit de traitement (CSC) met en oeuvre les opérations logiques suivantes :

$$D1 = N[C1].C2,$$

$$D2 = C1.N[C2]$$

dans lesquelles D1 et D2 sont les signaux logiques de contrôle élaborés lors d'une transition en cours, C1 et C2 sont les signaux logiques de contrôle obtenus lors d'une transition précédente, N[x] représente l'opération logique d'inversion appliquée au signal x, et "." représente l'opération logique ET.

9. Machine d'état selon l'une des revendications 6 à 8, dans laquelle le circuit de contrôle (CHKL) élabore un signal d'erreur (ER) en fonction de la comparaison du signal de contrôle (D1, D2) avec la valeur attendue (F1, F2) .

10. Machine d'état selon l'une des revendications 6 à 9, comportant un réseau logique programmable (CBL) comprenant des inverseurs d'entrée (I1), des circuits logiques produit (ADl-ADm, ADc), des circuits logiques somme (ODl-ODp, ODc), et des moyens de configuration (IM1, IM2) pour connecter sélectivement des entrées de la machine d'état (E1-En) et des sorties des inverseurs d'entrée à des circuits logiques produit, et pour connecter sélectivement des sorties (P1-Pm) des circuits logiques produit à des entrées de circuits logiques somme, le circuit de traitement (CSC) comprenant pour chaque signal logique de contrôle (D1, D2) un circuit logique produit (AD1, AD2) connecté à un circuit logique somme (OD1, OD2) fournissant le signal logique de contrôle.

11. Machine d'état selon la revendication 10, dans laquelle les circuits logiques produit (AD1, AD2) et les circuits logiques somme (OD1, OD2) fournissant les signaux logiques de contrôle (D1, D2) sont configurés pour que la génération des signaux logiques de contrôle soit ralentie.

**Claims**

1. Method for detecting a dysfunction in a state machine (FSM) having an operation modelled by a set of states linked between them by transitions, the state machine producing at each transition output signals (PO, SO) as a function of input signals (PI, SI) comprising signals (PI) produced during a previous transition,
   **characterised in that** it comprises:

   - defining in the state machine a processing circuit (CSC) to produce at least one control signal (CSO) as a function of a control signal (CSI) produced during a previous transition,
   - the processing circuit producing, during a transition, the control signal (CSO) as a function of a control signal (CSI) produced by the processing circuit during a previous transition,
   - determining during the transition an expected value for each control signal (F1, F2), and
   - comparing each control signal produced with the expected value.

2. Method according to claim 1, comprising elaborating two control logic signals (D1, D2) which are the opposite of one another and which are reverted at each transition of the state machine (FSM).

3. Method according to claim 2, wherein the control logic signals D1, D2 are obtained by the following logic operations:

$$D1 = N[C1].C2,$$

$$D2 = C1.N[C2]$$

where C1 and C2 are the control logic signals obtained during a previous transition, N[x] is the logic inversion operation applied to the signal x, and "." is the logic operation AND.

4. Method according to one of claims 1 to 3, comprising generating an error signal (ER) as a function of the result of the comparison step.

5. Method according to one of claims 1 to 4, wherein producing the control signals (D1, D2) is slowed down.

6. State machine (FSM) which operation is modelled by a set of states linked between them by transitions, and producing at each transition output signals (PO, SO) as a function of input signals (PI, SI) comprising signals (PI) produced during a previous transition,
   **characterised in that** it comprises a processing circuit (CSC) to produce at least one control signal (D1, D2) during a transition of the state machine, as a function of a control signal (C1, C2) produced by the processing circuit during a previous transition, and a control circuit (CHKL) to determine an expected value for each control signal (F1, F2) and compare the control signal with the expected value.

7. State machine according to claim 6, wherein the processing circuit (CSC) produces two control logic signals (D1, D2) which are the opposite of one another and which are reverted at each transition of the state machine (FSM).

8. State machine according to claim 6 or 7, wherein the processing circuit (CSC) implements the following logic operations:

$$D1 = N[C1].C2,$$

$$D2 = C1.N[C2]$$

where D1 and D2 are the control logic signals produced during a transition in progress, C1 and C2 are the control logic signals obtained during a previous transition, N[x] is the logic inversion operation applied to the signal x, and "." is the logic operation AND.

9. State machine according to one of claims 6 to 8, wherein the control circuit (CHKL) produces an error signal (ER) as a function of the comparison of the control signal (D1, D2) with the expected value (F1, F2).

10. State machine according to one of claims 6 to 9, comprising a programmable logic network (CBL) comprising input inverting circuits (I1), product logic circuits (AD1-ADm, ADc), sum logic circuits (ODl-ODp, ODc), and configuration means (IM1, IM2) to selectively connect inputs of the state machine (E1, En) and outputs of the input inverting circuits to product logic circuits, and to selectively connect outputs (P1-Pm) of the product logic circuits to inputs of sum logic circuits, the processing circuit (CSC) comprising for each control logic signal (D1, D2) a product logic circuit (AD1, AD2) connected to a sum logic circuit (OD1, OD2) supplying the control logic signal.

11. State machine according to claim 10, wherein the product logic circuits (AD1, AD2) and the sum logic circuits (OD1, OD2) supplying the control logic signal (D1, D2) are configured so that generating the control logic signals is slowed down.

**Patentansprüche**

1. Verfahren zum Erfassen einer Betriebsstörung in einer Zustandsmaschine (FSM), die eine Funktionsweise hat, die von einer Einheit von Zuständen, die untereinander durch Übergänge verbunden sind, modelliert ist, wobei die Zustandsmaschine bei jedem Übergang Ausgangssignale (PO, SO) in Abhängigkeit von Eingangssignalen (PI, SI), die Signale (PI) aufweisen, die bei einem vorhergehenden Übergang erstellt werden, erstellt,
**dadurch gekennzeichnet, dass** es die folgenden Schritte aufweist:

- in der Zustandsmaschine Definieren einer Verarbeitungsschaltung (CSC) zum Erstellen mindestens eines Steuersignals (CSO) in Abhängigkeit von einem Steuersignal (CSI), das bei einem vorhergehenden Übergang erstellt wurde,
- während eines Übergangs Erstellen durch die Verarbeitungsschaltung des Steuersignals (CSO) in Abhängigkeit von einem Steuersignal (CSI), das von der Verarbeitungsschaltung bei einem vorhergehenden Übergang erstellt wurde,
- während des Übergangs Bestimmen eines erwarteten Werts jedes Steuersignals (F1, F2) und
- Vergleichen jedes erstellten Steuersignals mit dem erwarteten Wert.

2. Verfahren nach Anspruch 1, das Erstellungsschritte von zwei logischen Steuersignalen (D1, D2) aufweist, die zueinander umgekehrt sind und bei jedem Übergang der Zustandsmaschine (FSM) umgekehrt werden.

3. Verfahren nach Anspruch 2, bei dem die logischen Steuersignale D1, D2 durch die folgenden logischen Operationen erzielt werden:

$$D1 = N[C1].C2,$$

$$D2 = C1.N[C2]$$

wobei C1 und C2 die logischen Steuersignale sind, die bei einem vorhergehenden Übergang erzielt wurden, N[x] die logische Operation des Umkehrens darstellt, die auf das Signal x angewandt wird, und "." die logische Operation UND darstellt.

4. Verfahren nach einem der Ansprüche 1 bis 3, das einen Schritt des Erzeugens eines Fehlersignals (ER) in Abhängigkeit von dem Ergebnis des Vergleichsschritts aufweist.

5. Verfahren nach einem der Ansprüche 1 bis 4, bei dem das Erstellen der Steuersignale (D1, D2) verlangsamt ist.

6. Zustandsmaschine (FSM), die eine Funktionsweise hat, die von einer Einheit Zustände, die untereinander durch Übergänge verbunden sind, modelliert ist, und die bei jedem Übergang Ausgangssignale (PO, SO) in Abhängigkeit von Eingangssignalen (PI, SI) erstellt, die Signale (PI) enthalten, die bei einem vorhergehenden Übergang erstellt wurden,
   **dadurch gekennzeichnet, dass** sie eine Verarbeitungsschaltung (CSC) aufweist, um mindestens ein Steuersignal (D1, D2) während eines Übergangs der Zustandsmaschine in Abhängigkeit von einem Steuersignal (C1, C2), das von der Verarbeitungsschaltung bei einem vorhergehenden Übergang erstellt wurde, zu erstellen, und eine Steuerschaltung (CHKL), um einen erwarteten Wert jedes Steuersignals (F1, F2) zu bestimmen und das Steuersignal mit dem erwarteten Wert zu vergleichen.

7. Zustandsmaschine nach Anspruch 6, bei der die Verarbeitungsschaltung (CSC) zwei logische Steuersignale (D1, D2) erstellt, die zueinander umgekehrt sind und bei jedem Übergang der Zustandsmaschine (FSM) umgekehrt werden.

8. Zustandsmaschine nach Anspruch 6 oder 7, bei der die Verarbeitungsschaltung (CSC) die folgenden logischen Operationen anwendet:

$$D1 = N[C1].C2,$$

$$D2 = C1.N[C2]$$

wobei D1 und D2 logische Steuersignale sind, die bei einem laufenden Übergang erstellt werden, wobei C1 und C2 logische Steuersignale sind, die bei einem vorhergehenden Übergang erzielt wurden, N[x] die logische Umkehroperation, die auf das Signal x angewandt wird, darstellt, und "." die logische Operation UND darstellt.

9. Zustandsmaschine nach einem der Ansprüche 6 bis 8, bei dem die Steuerschaltung (CHKL) ein Fehlersignal (ER) in Abhängigkeit von dem Vergleich des Steuersignals (D1, D2) mit dem erwarteten Wert (F1, F2) erstellt.

10. Zustandsmaschine nach einem der Ansprüche 6 bis 9, die ein programmierbares logisches Netz (CBL) aufweist, das Eingangsumkehrer (I1), logische Produktschaltungen (AD1-ADm, ADc), logische Summenschaltungen (OD1-ODp, ODc) und Konfigurationsmittel (IM1, IM2) aufweist, um Eingänge (EI-En) der Zustandsmaschine und Ausgänge der Eingangsumkehrer an logische Produktschaltungen selektiv anzuschließen, und um Ausgänge (P1-Pm) der logischen Produktschaltungen an Eingänge von logischen Summenschaltungen selektiv anzuschließen, wobei die Verarbeitungsschaltung (CSC) für jedes logische Steuersignal (D1, D2) eine logische Produktschaltung (AD1, AD2) aufweist, die an eine logische Summenschaltung (OD1, OD2), die das logische Steuersignal liefert, angeschlossen ist.

11. Zustandsmaschine nach Anspruch 10, bei der die logischen Produktschaltungen (AD1, AD2) und die logischen Summenschaltungen (OD1, OD2), die die logischen Steuersignale (D1, D2) liefern, konfiguriert sind, damit das Erzeugen der logischen Steuersignale verlangsamt ist.

Fig. 1

Fig. 2

Fig. 3

Fig. 4

Fig. 5

Fig. 7

Fig. 6

Fig. 8

Fig. 9

Fig. 10

Fig. 11

Fig. 12

**EP 1 816 484 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **M. K. STOJCEV et al.** VHDL-Based Design of FSM with Concurrent Error Detection Capability. *Proc. 24th International Conference on Microelectronics (MIEL 2004),* 16 Mai 2004, vol. 2